(19) **Europäisches Patentamt / European Patent Office / Office européen des brevets**

(11) **EP 4 478 070 B1**

(12) **FASCICULE DE BREVET EUROPÉEN**

(45) Date de publication et mention de la délivrance du brevet:
**03.09.2025 Bulletin 2025/36**

(21) Numéro de dépôt: **24179289.4**

(22) Date de dépôt: **31.05.2024**

(51) Classification Internationale des Brevets (IPC):
***G01R 31/52*** *(2020.01)*

(52) Classification Coopérative des Brevets (CPC):
**G01R 31/52**

(54) **DISPOSITIF DE DÉTECTION DE COURT-CIRCUIT**

KURZSCHLUSSDETEKTIONSVORRICHTUNG

SHORT CIRCUIT DETECTION DEVICE

(84) Etats contractants désignés:
AL AT BE BG CH CY CZ DE DK EE ES FI FR GB GR HR HU IE IS IT LI LT LU LV MC ME MK MT NL NO PL PT RO RS SE SI SK SM TR

(30) Priorité: **13.06.2023 FR 2306003**

(43) Date de publication de la demande:
**18.12.2024 Bulletin 2024/51**

(73) Titulaire: **STMicroelectronics International N.V.**
**1228 Plan-les-Ouates, Geneva (CH)**

(72) Inventeurs:
- **BENABDELAZIZ, Ghafour**
  **37100 TOURS (FR)**
- **PROOT, Jean Pierre**
  **37540 SAINT CYR SUR LOIRE (FR)**

(74) Mandataire: **Cabinet Beaumont**
**4, Place Robert Schuman**
**B.P. 1529**
**38025 Grenoble Cedex 1 (FR)**

(56) Documents cités:
CN-A- 101 515 710   CN-A- 108 448 548
CN-A- 115 128 426

## Description

Domaine technique

La présente description concerne de façon générale un dispositif de détection de court-circuit.

Technique antérieure

Dans un circuit à courant continu par exemple présent dans un véhicule électrique, la batterie du véhicule est reliée à un bus comprenant deux éléments conducteurs chacun couplé à l'une des bornes de la batterie. Les éléments capacitifs du circuit couplés au bus peuvent être assimilés à une capacité de stockage, ou « bulk capacitor » en anglais, couplée parallèlement à la batterie par l'intermédiaire des éléments conducteurs du bus et de relais permettant de connecter et déconnecter la batterie vis-à-vis du bus.

Lorsque les relais sont fermés pour connecter le bus à la batterie, un important courant d'appel circule entre la batterie et la capacité de stockage. Pour éviter l'apparition de ce courant d'appel, la capacité de stockage est généralement préchargée avec un courant de précharge avant la fermeture des relais. Pour cela, il est possible de coupler, parallèlement à un des relais, un circuit de précharge comprenant une résistance de précharge et un commutateur. La précharge de la capacité de stockage est mise en œuvre en rendant passant ce commutateur et en maintenant ouvert le relais qui est couplé parallèlement au circuit de précharge, l'autre relais étant fermé. Cette phase de précharge est mise en œuvre pendant une durée suffisante pour obtenir, aux bornes de la capacité de stockage, la tension de précharge souhaitée.

Si un court-circuit est présent dans le circuit à courant continu, un courant très important circule à travers le commutateur et peut endommager les autres éléments couplés au bus. Lorsque le commutateur du circuit de précharge correspond à un thyristor, un blocage du thyristor permettant d'arrêter ce courant de court-circuit requiert de faire appel à un circuit supplémentaire.

Lorsque le commutateur du circuit de précharge correspond à un relais, il est possible d'ouvrir simplement le relais pour stopper le courant de court-circuit. Toutefois, compte tenu du délai nécessaire à l'ouverture du relai et des phénomènes de rebonds et d'arcs électriques, le courant de court-circuit peut endommager, pendant ce délai, les autres éléments couplés au bus. De plus, ce délai d'ouverture du relai augmente avec le temps. Un état de la technique pertinent est divulgué dans le document CN101515710.

Résumé de l'invention

Il existe un besoin de proposer une solution permettant de répondre aux problèmes rencontrés avec les solutions existantes.

Un mode de réalisation particulier répond à au moins une partie de ces problèmes et propose un Dispositif de détection de court-circuit dans un circuit de courant continu comprenant au moins une source de tension, un bus comportant au moins deux éléments conducteurs chacun couplé à l'une des bornes de la source de tension, des premier et deuxième thyristors couplés à la source de tension et au bus, et au moins un élément capacitif formant une capacité de stockage dont chacune des électrodes est couplée à l'un des deux éléments conducteurs du bus,

le dispositif de détection de court-circuit comprenant au moins un circuit de commande configuré pour commander les polarisations et les régimes de fonctionnement des premier et deuxième thyristors tel que :

- lors d'une phase de détection de court-circuit, le premier thyristor est mis à l'état bloqué et le deuxième thyristor est polarisé en inverse et conduit un courant inverse non nul chargeant la capacité de stockage, puis une tension aux bornes de la capacité de stockage est déterminée ; puis

- si la tension déterminée aux bornes de la capacité de stockage est inférieure ou égale à une valeur seuil de court-circuit, les premier et deuxième thyristors sont bloqués, ou si la tension déterminée aux bornes de la capacité de stockage est supérieure à la valeur seuil de court-circuit, la capacité de stockage est préchargée en bloquant le deuxième thyristor et en rendant passant le premier thyristor (112).

Dans un mode de réalisation particulier, la valeur seuil de court-circuit est égale à 0.

Dans un mode de réalisation particulier, le dispositif de détection de court-circuit est tel que :

- la source de tension est une source de tension continue comportant au moins une batterie ;

- le circuit de courant continu comporte au moins un premier commutateur couplant une borne positive de la batterie à un premier des deux éléments conducteurs du bus, et au moins un deuxième commutateur couplant une borne négative de la batterie à un deuxième des deux éléments conducteurs du bus ;

- au moins l'un des premier et deuxième commutateurs correspond à un relais ;

- le circuit de courant continu comporte un circuit de décharge de la capacité de stockage incluant au moins un troisième commutateur couplé en série à au moins une résistance de décharge, le circuit de décharge étant couplé en parallèle de la capacité de stockage ;

- le premier thyristor fait partie d'un circuit de précharge incluant en outre une résistance de précharge couplée en série au premier thyristor, le circuit de précharge étant couplé en parallèle de l'un des premier et deuxième commutateurs et tel que la cathode du premier thyristor soit couplée à la borne négative de la batterie ou que l'anode du premier thyristor soit couplée à la borne positive de la batterie ;

- le deuxième thyristor est couplé en parallèle de l'un des premier et deuxième commutateurs et tel que l'anode du deuxième thyristor est couplée à la borne négative de la batterie ou la cathode du deuxième thyristor est couplée à la borne positive de la batterie.

Dans un mode de réalisation particulier, le dispositif de détection de court-circuit est tel que :

- le circuit de commande est configuré pour appliquer des signaux de commande sur les gâchettes des premier et deuxième thyristors, ou

- le dispositif de détection de court-circuit comporte en outre une diode Zener et un circuit RC, l'anode de la diode Zener étant couplée à la gâchette du premier thyristor, la cathode de la diode Zener étant couplée à l'anode du deuxième thyristor et à une première borne du circuit RC, une deuxième borne du circuit RC étant couplée à la cathode du premier thyristor.

Dans un mode de réalisation particulier, le circuit de commande est configuré pour :

- avant la phase de détection de court-circuit, fermer le premier commutateur, puis réaliser une mesure initiale de la tension aux bornes de la capacité de stockage ; puis
- mettre en œuvre la phase de détection de court-circuit si la tension initialement mesurée aux bornes de la capacité de stockage est inférieure ou égale à la valeur seuil de court-circuit, ou précharger directement la capacité de stockage si la tension initialement mesurée aux bornes de la capacité de stockage est supérieure à la valeur seuil de court-circuit.

Dans un mode de réalisation particulier, lorsque l'anode du deuxième thyristor est couplée à la borne négative de la batterie, le circuit de commande est configuré pour commander le premier commutateur tel qu'il soit passant lors de la phase de détection de court-circuit et lors de la précharge de la capacité de stockage.

Dans un mode de réalisation particulier, le circuit de commande est configuré tel que, après la précharge de la capacité de stockage, les premier et deuxième commutateurs sont mis à l'état passant et les premier et deuxième thyristors sont bloqués.

Dans un mode de réalisation particulier, le troisième commutateur est un troisième thyristor, et le circuit de commande est configuré pour appliquer un signal de commande sur la gâchette du troisième thyristor.

Dans un mode de réalisation particulier, lors d'une phase de déconnexion de la batterie vis-à-vis du bus mise en œuvre après la précharge de la capacité de stockage, le circuit de commande est configuré pour rendre passant le troisième commutateur après avoir ouvert les premier et deuxième commutateurs.

Dans un mode de réalisation particulier, lors de la détermination de la tension aux bornes de la capacité de stockage mise en œuvre pendant la phase de détection de court-circuit, le circuit de commande est configuré pour bloquer le deuxième thyristor.

Un autre mode de réalisation particulier propose un système de contrôle de batterie de véhicule, comprenant au moins un dispositif de détection de court-circuit tel que proposé ci-dessus.

Un autre mode de réalisation particulier propose un convertisseur de puissance électrique comprenant au moins un dispositif de détection de court-circuit tel que proposé ci-dessus.

Dans un mode de réalisation particulier, les premier et deuxième thyristors font partie des cellules de commutation du convertisseur de puissance électrique.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

- la figure 1 représente schématiquement un premier exemple de réalisation d'un dispositif de détection de court-circuit selon un mode de réalisation particulier ;

- la figure 2 et la figure 3 représentent des chronogrammes de signaux du dispositif de détection de court-circuit selon le premier exemple de réalisation ;

- la figure 4 représente schématiquement un deuxième exemple de réalisation d'un dispositif de détection de court-circuit selon un mode de réalisation particulier ;

- la figure 5 représente un chronogramme de signaux du dispositif de détection de court-circuit selon le deuxième exemple de réalisation ;

- la figure 6 représente schématiquement un exemple de réalisation d'un convertisseur de puissance comprenant un dispositif de détection de court-circuit selon un mode de réalisation particulier.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, différents éléments (source de tension, bus, thyristor, circuit de commande, etc.) du dispositif de détection de court-circuit ne sont pas détaillés. L'homme du métier sera à même de réaliser de manière détaillée ces éléments à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

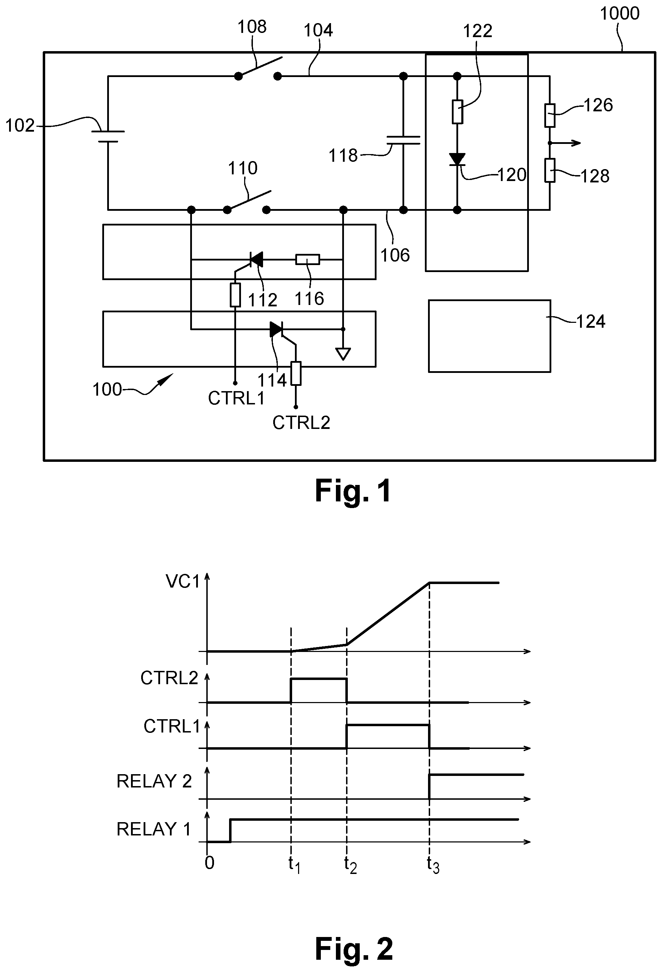

En outre, les signaux des chronogrammes des figures 2, 3 et 5 sont représentés schématiquement et non à l'échelle les uns par rapport aux autres, autant pour les amplitudes que pour les durées des différentes parties de ces signaux. Ainsi, les signaux représentés symboliquement en forme de créneaux sur ces figures peuvent correspondre à des signaux impulsionnels ou d'autres formes de signaux.

Un premier exemple de réalisation d'un dispositif 100 de détection de court-circuit est décrit ci-dessous en lien avec la figure 1.

Dans ce premier exemple de réalisation, le dispositif 100 permet de détecter un court-circuit dans un circuit de courant continu faisant par exemple partie d'un système de 1000 contrôle de batterie de véhicule tel qu'une voiture électrique, avant que la batterie soit connectée au bus du circuit de courant continu du véhicule.

Le circuit de courant continu comprend au moins une source de tension 102 qui, dans ce premier exemple de réalisation, correspond à source de tension continue comportant au moins une batterie et délivrant un courant continu. A titre d'exemple, la tension délivrée aux bornes de la batterie est par exemple de l'ordre de 400 V ou de 800 V.

Le circuit de courant continu comprend également un bus comportant au moins deux éléments conducteurs 104, 106 chacun couplé à l'une des bornes de la source de tension 102. Dans le premier exemple de réalisation décrit, le premier élément conducteur 104 est couplé à la borne positive de la source de tension 102 à travers un premier commutateur 108, et le deuxième élément conducteur 106 est couplé à la borne négative de la source de tension 102 à travers un deuxième commutateur 110.

Dans ce premier exemple de réalisation, au moins l'un des premier et deuxième commutateurs 108, 110 correspond à un relais afin de pouvoir couper physiquement la source de tension 102 vis-à-vis du bus, sans courant de fuite parasite. Sur l'exemple de la figure 1, les deux commutateurs 108, 110 correspondent à des relais. En variante, l'un des deux commutateurs 108, 110 peut ne pas être un relais et peut correspondre par exemple à un dispositif semiconducteur tel qu'un transistor de puissance ou tout autre composant électronique adapté pour former un tel commutateur.

Le dispositif 100 comprend également des premier et deuxième thyristors 112, 114 couplés à la source de tension 102 et au bus.

Dans le premier exemple de réalisation décrit, le premier thyristor 112 fait partie d'un circuit de précharge incluant en outre une résistance de précharge 116 couplée en série au premier thyristor 112. Le circuit de précharge est couplé en parallèle de l'un des premier et deuxième commutateurs 108, 110 (en parallèle du deuxième commutateur 110 sur l'exemple de la figure 1). De plus, sur l'exemple de la figure 1, la cathode du premier thyristor 112 est couplée à la borne négative de la source de tension 102. En variante, le circuit de précharge peut être couplé en parallèle du premier commutateur 108, avec dans ce cas l'anode du premier thyristor 112 qui est couplée à la borne positive de la source de tension 102.

Sur l'exemple de la figure 1, le deuxième thyristor 114 forme un circuit de détection de court-circuit couplé en parallèle de l'un des premier et deuxième commutateurs 108, 110. Sur l'exemple de la figure 1, le deuxième thyristor 114 est couplé en parallèle du deuxième commutateur 110. De plus, l'anode du deuxième thyristor 114 est couplée à la borne négative de la source de tension 102. En variante, le deuxième thyristor 114 peut être couplé en parallèle du premier commutateur 108, avec dans ce cas la cathode du deuxième thyristor 114 qui est couplée à la borne positive de la source de tension 102.

Dans le mode de réalisation particulier décrit, le circuit de courant continu comporte un ou plusieurs éléments capacitifs formant ensemble une capacité de stockage 118 dont chacune des électrodes est couplée à l'un des deux éléments conducteurs 104, 106 du bus.

Dans l'exemple de réalisation décrit, le dispositif 100 comporte également un circuit de décharge de la capacité de stockage 118 incluant au moins un troisième commutateur 120 couplé en série à une résistance de décharge 122. Ce circuit de décharge est couplé en parallèle de la capacité de stockage 118. Sur l'exemple de réalisation représenté sur la figure 1, le troisième commutateur 120 correspond à un troisième thyristor.

Le dispositif 100 comprend également au moins un circuit de commande 124, comportant par exemple au moins un microcontrôleur, configuré pour commander la polarisation des premier, deuxième et troisième thyristors 112, 114, 120, notamment grâce à la commande d'ouverture ou de fermeture de chacun des premier et deuxième commutateurs 108, 110, ainsi que les régimes de fonctionnement des premier, deuxième et troisième thyristors 112, 114, 120. Dans le premier exemple de réalisation décrit, les régimes de fonctionnement des premier, deuxième et troisième thyristors 112, 114 et 120 sont commandés grâce à des signaux de commande appliqués sur les gâchettes des thyristors 112, 114, 120 par le circuit de commande 124. Sur la figure 1, un signal de commande « CTRL1 » est appliqué sur la gâchette du premier thyristor 112, un signal de commande « CTRL2 » est appliqué sur la gâchette du deuxième thyristor 114 et un signal de commande « CTRL3 » est appliqué sur la gâchette du troisième thyristor 120. Sur la figure 1, les liaisons électriques entre les commutateurs 108, 110 et le circuit de commande 124 et entre les thyristors 112, 114, 120 et le circuit de commande 124 ne sont pas représentées.

Dans le mode de réalisation particulier décrit, le dispositif 100 comporte également un pont diviseur de tension couplé aux éléments conducteurs 104, 106 du bus, parallèlement à la capacité de stockage 118. Sur l'exemple de la figure 1, ce pont diviseur de tension comporte deux résistances 126, 128. La tension mesurée aux bornes de l'une des résistances 126, 128 permet, en connaissant les valeurs des résistances 126, 128, de déterminer la valeur de la tension aux bornes de la capacité de stockage 128, c'est-à-dire de la tension sur bus de courant continu.

En outre, sur l'exemple de la figure 1, les gâchettes des premier et deuxième thyristors 112, 114 sont couplées à des résistances à travers lesquelles les signaux de commande sont appliqués.

Bien que non représenté, un fusible peut être présent entre la source de tension 102 et le bus. En outre, d'autres composants ou circuits, comme par exemple des convertisseurs de puissance, peuvent être connectés également au bus, ces éléments n'étant pas représentés sur les différentes figures.

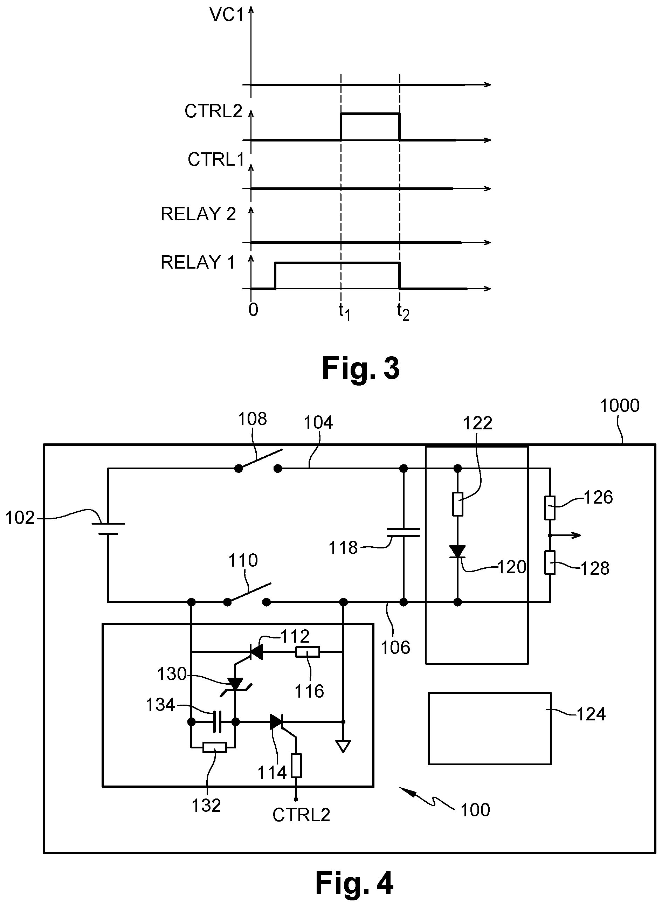

Un exemple d'un procédé mis en œuvre par le dispositif 100 précédemment décrit en lien avec la figure 1 est décrit ci-dessous. La figure 2 représente des exemples de signaux de commande et de mesure obtenus au cours de ce procédé qui correspond à un procédé de connexion de la source de tension 102 au bus, avec une vérification préalable de la présence d'un court-circuit sur le circuit de courant continu. La figure 3 représente ces mêmes signaux lorsqu'un court-circuit est détecté sur le circuit, conduisant au maintien de la source de tension 102 non connectée au bus.

Sur les figures 2 et 3, une valeur haute des signaux « RELAY1 » et « RELAY2 » représente une commande de fermeture des commutateurs 108, 110 et une valeur basse de ces signaux représente une commande d'ouverture de ces commutateurs 108, 110. De plus, une valeur haute des signaux « CTRL1 » et « CTRL2 » représente une commande de mise à l'état passant des thyristors 112, 114 et une valeur basse de ces signaux représente une commande de blocage de ces thyristors 112, 114.

Dans l'exemple de réalisation décrit, à l'état initial de ce procédé, les premier et deuxième commutateurs 108, 110 sont ouverts et les premier, deuxième et troisième thyristors 112, 114, 120 sont bloqués.

Dans une première phase du procédé, qui correspond à la durée allant de l'instant $t_0$ à l'instant $t_1$ visible sur les figures 2 et 3, le circuit de commande 124 envoie au premier commutateur 108 un premier signal de commande, appelé « RELAY1 » sur les figures 2 et 3, commandant sa fermeture.

Dans cet exemple, la tension aux bornes de la capacité de stockage 118 est déterminée pendant cette première phase, par exemple à partir d'une mesure de la tension aux bornes de l'une des résistances 126, 128, et comparée à une valeur seuil de court-circuit. Cette valeur seuil de court-circuit est par exemple égale à 0 et définit une limite telle que si, au cours de cette première phase, la tension aux bornes de la capacité de stockage 118 est supérieure à cette valeur seuil, cela signifie qu'un court-circuit n'est pas présent dans le circuit de courant continu. Le procédé peut alors directement passer à la phase de précharge de la capacité de stockage 118 décrite plus loin.

Si, au cours de cette première phase du procédé, la tension aux bornes de la capacité de stockage 118 reste inférieure ou égale à cette valeur seuil, cela signifie que la capacité de stockage 118 n'est pas chargée électriquement ou qu'un court-circuit est présent dans le circuit de courant continu. Sur les exemples des figures 2 et 3, la tension aux bornes de la capacité de stockage 118, appelée « VC1 », reste nulle même après avoir fermé le premier commutateur 108, ce qui signifie qu'un court-circuit est peut-être présent dans le circuit de courant continu. Une phase de détection de court-circuit est dans ce cas mise en œuvre.

La phase de détection de court-circuit est mise en œuvre entre les instants $t_1$ et $t_2$ visibles sur les figures 2 et 3. Pendant cette phase, le premier thyristor 112 est bloqué (sur les figures 2 et 3, le signal de commande « CTRL2 » envoyé par le circuit de commande 124 sur la gâchette du premier thyristor 112 reste nul) et le deuxième thyristor 114, qui est polarisé en inverse, conduit un courant inverse non nul pendant la durée $t_2 - t_1$. Cette conduction d'un courant inverse par le deuxième thyristor 114 est obtenue grâce à sa polarisation inverse et l'application, par le circuit de commande 124, d'un courant sur la gâchette du deuxième thyristor 114 qui engendre cette conduction. La valeur du courant de conduction inverse obtenu est proportionnelle à la valeur du courant appliqué sur la gâchette du deuxième thyristor 114, la valeur du coefficient de proportionnalité $\beta$ entre ces deux

courants étant fonction des caractéristiques du deuxième thyristor 114. A titre d'exemple, le courant appliqué sur la gâchette du deuxième thyristor 114 peut être de l'ordre de 16 mA, ou plus généralement compris entre 10 mA et 16 mA afin d'obtenir un courant de conduction inverse compris entre 6 mA et 10 mA.

Sur la figure 2, la circulation de ce faible courant inverse à travers le deuxième thyristor 114 engendre une lente charge de la capacité de stockage 118, et donc une faible augmentation de la tension aux bornes de la capacité de stockage 118. A titre d'exemple, cette faible augmentation de la tension aux bornes peut être égale à 10 V, ou plus généralement comprise entre 1% et 5% de la tension de la batterie. Sur la figure 3, la circulation de ce faible courant inverse à travers le deuxième thyristor 114 ne charge pas la capacité de stockage 118 à cause de la présence d'un court-circuit dans le circuit de courant continu. Cette tension est déterminée, par exemple par une mesure sur le pont diviseur de tension, puis comparée à la valeur seuil de court-circuit. La durée t de cette phase de détection de court-circuit peut s'exprimer par l'équation suivante :

$$t = C \times \frac{\Delta V}{I_R}$$

avec C la valeur de la capacité de stockage 118, $\Delta V$ l'augmentation de la tension aux bornes de la capacité de stockage 118, et $I_R$ le courant de conduction inverse chargeant la capacité de stockage 118. A titre d'exemple, pour un courant $I_R$ égale à 16 mA, une capacité C de 0,67 mF et une augmentation de tension $\Delta V$ de 10 V, la durée t est égale à 425 ms.

Si la tension déterminée est inférieure ou égale à la valeur seuil de court-circuit, par exemple égale à 0 dans l'exemple décrit ici, les premier et deuxième thyristors 112, 114 sont bloqués, et le procédé s'achève étant donné que cela signifie qu'un court-circuit est bien détecté dans le circuit de courant continu. La source de tension 102 n'est, dans ce cas, pas connectée au bus. Ce cas de figure correspond à celui représenté sur la figure 3, dans laquelle la tension VC1 est nulle à l'instant $t_2$. En présence d'un court-circuit, le premier commutateur 108 est alors ouvert (signal « RELAY 1 » passant à la valeur basse à partir de $t_2$).

Si la tension déterminée est supérieure à la valeur seuil de court-circuit, comme c'est le cas sur le chronogramme de la figure 2, une phase de précharge de la capacité de stockage 118 est mise en œuvre. Le deuxième thyristor 114 est bloqué (signal « CTRL2 » passant à la valeur basse) et le premier thyristor 112, qui est polarisé en direct, est mis à l'état passant par le circuit de commande 124 qui applique, sur la gâchette du premier thyristor 112, le signal « CTRL1 » de valeur haute. La capacité de stockage 118 se charge alors plus rapidement que pendant la phase de détection de court-circuit du fait que le courant traversant la capacité de stockage 118 n'est limité que par la résistance de précharge 116, et non plus par la conduction inverse du deuxième thyristor 114.

L'instant $t_3$ visible sur la figure 2 correspond à l'instant à partir duquel la valeur de tension de précharge souhaitée est atteinte aux bornes de la capacité de stockage 118. A titre d'exemple, cette valeur souhaitée de tension de précharge peut être comprise entre 80 % et 90 % de la tension aux bornes la source de tension 102. La commande appliquée sur la gâchette du premier thyristor 112 est alors retirée (signal « CTRL1 » passant à la valeur basse) et le deuxième commutateur 110 est fermé. Le premier thyristor 112 passe alors naturellement à l'état bloqué car le courant va alors passer par le deuxième commutateur 110 au lieu du premier thyristor 112, connectant ainsi la source de tension 102 au bus (le premier commutateur 108 reste fermé après l'instant $t_3$).

Ainsi, en commandant les différents éléments du dispositif 100 comme décrit ci-dessus, le courant circulant dans le bus est surveillé avant le début de la précharge de la capacité de stockage 118, ce qui permet d'éviter la mise en œuvre d'une telle précharge si un court-circuit est détecté sur le bus. En outre, l'intégrité d'un éventuel fusible présent entre la source de tension 102 et le bus est préservée.

Lorsque la source de tension 102 doit être déconnectée du bus, par exemple lors de l'arrêt du véhicule, après (ou même pendant) la précharge de la capacité de stockage 118, le circuit de commande 124 met à l'état passant le troisième thyristor 120 et ouvre les premier et deuxième commutateurs 108, 110. La capacité de stockage 118 se décharge alors à travers la résistance de décharge 122 qui limite la valeur du courant lors de cette phase de décharge.

Un deuxième exemple de réalisation d'un dispositif 100 de détection de court-circuit est décrit ci-dessous en lien avec la figure 4.

Le dispositif 100 selon le deuxième exemple de réalisation comporte tous les éléments du dispositif 100 selon le premier exemple de réalisation précédemment décrit en lien avec la figure 1.

Outre ces éléments, le dispositif 100 selon ce deuxième exemple de réalisation comporte une diode Zener 130 dont l'anode est couplée à la gâchette du premier thyristor 112. La cathode de la diode Zener 130 est couplée à une borne d'un circuit RC comprenant une résistance 132 et un condensateur 134 et à l'anode du deuxième thyristor 114. Une deuxième borne du circuit RC est couplée à la cathode du premier thyristor 112.

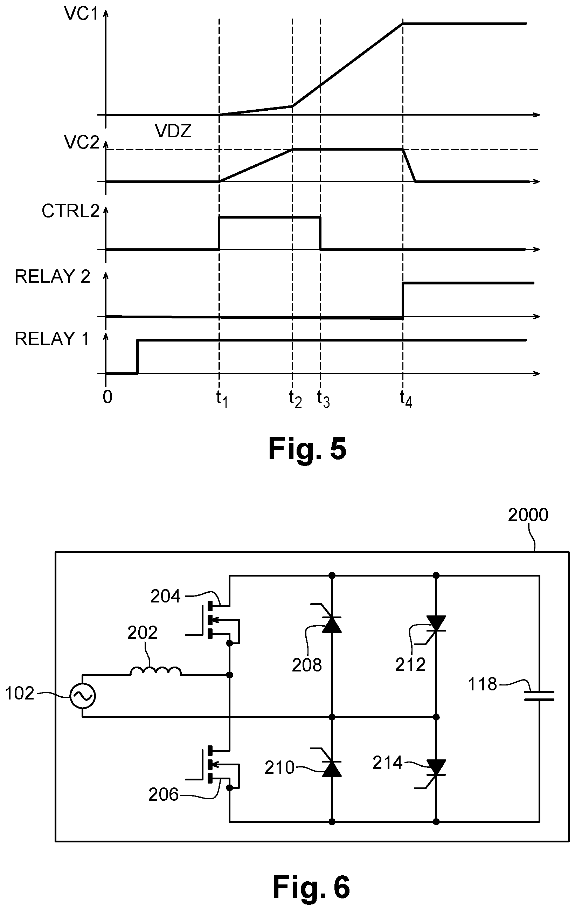

Un chronogramme des signaux du dispositif 100 selon le deuxième exemple de réalisation, lors d'une détection de court-circuit préalablement à une connexion de la source de tension 102 au bus, est représenté sur la figure 5.

Sur ce chronogramme, les différents signaux représentés correspondent à ceux précédemment décrits en lien avec les figures 2 et 3, excepté le signal « VC2 » qui correspond à la tension aux bornes de la diode Zener 130.

Entre les instants 0 et $t_1$, c'est-à-dire pendant la mesure initiale de la tension aux bornes de la capacité de stockage 118, la tension aux bornes de la diode Zener 130 reste nulle. Les autres signaux sont similaires à ceux précédemment décrits en lien avec les figures 2 et 3. Comme précédemment, si la tension aux bornes de la capacité de stockage 118 qui est déterminée pendant cette première phase est supérieure au seuil de court-circuit, cela signifie qu'un court-circuit n'est pas présent dans le circuit de courant continu. Le procédé peut alors directement passer à la phase de précharge de la capacité de stockage 118. Si par contre cette tension reste inférieure ou égale à cette valeur seuil, cela signifie que la capacité de stockage 118 n'est pas chargée électriquement ou qu'un court-circuit est présent dans le circuit de courant continu. Dans ce cas, le procédé ne passe pas à la phase de précharge et signale la détection d'un éventuel court-circuit.

Entre les instants $t_1$ et $t_2$ (phase de détection de court-circuit), le deuxième thyristor 114 est polarisé en inverse et conduit un faible courant de conduction inverse chargeant lentement la capacité de stockage 118. Ce courant de conduction inverse charge également le condensateur 134, augmentant ainsi la tension VC2 aux bornes de la diode Zener 130. La tension aux bornes de la capacité 118 est ensuite déterminée et si celle-ci est supérieure au seuil de court-circuit, la phase de précharge de la capacité de stockage 118 débute. Si celle-ci est inférieure ou égale au seuil de court-circuit, le deuxième thyristor 114 est bloqué et les commutateurs 108, 110 sont ouverts.

Sur l'exemple de la figure 5, à l'instant $t_2$, la phase de précharge de la capacité de stockage 118 débute. Le premier thyristor 112 est mis à l'état passant via le signal de commande appliqué automatiquement sur la gâchette du premier thyristor 112 par la diode Zener 130 grâce à l'augmentation de la tension obtenue aux bornes de la diode Zener 130 lors de la phase de détection de court-circuit. L'instant $t_3$ représente symboliquement le passage à l'état bloqué du deuxième thyristor 114. Si un court-circuit avait été présent dans le circuit, le signal de commande appliqué sur la gâchette du deuxième thyristor 114 est retiré avant que la tension aux bornes du condensateur 134 n'atteigne la valeur de la tension de seuil de la diode Zener 130 afin d'éviter l'amorçage, et donc la mise à l'état passant, du premier thyristor 112.

L'instant $t_4$ visible sur la figure 5 correspond à l'instant à partir duquel la valeur de tension de précharge souhaitée est atteinte aux bornes de la capacité de stockage 118. Le deuxième commutateur 110 est alors fermé, connectant ainsi la source de tension 102 au bus (le premier commutateur 108 reste fermé après l'instant $t_4$).

Comme dans le premier exemple de réalisation précédemment décrit, en commandant les différents éléments du dispositif 100 selon le deuxième exemple de réalisation, le courant circulant dans le bus est donc surveillé avant le début de la précharge de la capacité de stockage 118 qui est déclenchée automatiquement, et évite la mise en œuvre d'une telle précharge si un court-circuit est détecté sur le bus.

Comme dans le premier exemple de réalisation, lorsque la source de tension 102 doit être déconnectée du bus, le circuit de commande 124 ouvre les premier et deuxième commutateurs 108, 110, puis met à l'état passant le troisième thyristor 120. La capacité de stockage 118 se décharge alors à travers la résistance de décharge 122.

Les différentes variantes précédemment décrites en lien avec le premier exemple de réalisation du dispositif 100 peuvent s'appliquer également au deuxième exemple de réalisation du dispositif 100.

Le dispositif de détection de court-circuit 100, décrit ci-dessus dans le cadre d'un système de contrôle de batterie de véhicule 1000, se base sur l'utilisation d'un thyristor polarisé en inverse et conduisant un courant inverse non nul lors d'une phase de détection de court-circuit pour augmenter la tension aux bornes de la capacité de stockage couplée au bus et vérifie la présence ou non d'un court-circuit avant de déclencher la précharge de la capacité de stockage en l'absence de court-circuit détecté.

Un tel dispositif 100 peut s'appliquer également au sein d'un convertisseur de puissance électrique 2000. Un exemple d'un tel convertisseur 2000 est décrit ci-dessous en lien avec la figure 6.

Sur l'exemple de la figure 6, le convertisseur 2000 est un convertisseur de puissance à correction de facteur de puissance de type totem pôle bidirectionnel, ou « bidirectionnal totem pole PFC » (PFC pour « Power factor Corrector »), et permet une conversion ou une adaptation d'une tension alternative vers une tension continue, ou inversement une conversion ou une adaptation d'une tension continue vers une tension alternative.

Dans cet exemple de réalisation, la source de tension 102 correspond à une source de tension alternative dont l'une des bornes est couplée à un élément inductif 202. Le convertisseur 200 comporte en outre des cellules de commutation formées par deux transistors 204, 206 et quatre thyristors 208, 210, 212 et 214. Les bras de commutation du convertisseur 2000 sont couplés en parallèle de la capacité de stockage 118. Le circuit de commande 124, commandant notamment la commutation des transistors et thyristors du convertisseur 2000, n'est pas visible sur cette figure 6.

Lorsque le convertisseur 2000 réalise une conversion ou une adaptation d'une tension alternative vers une tension continue, les composants utilisés pour les commutations sont les transistors 204, 206 et les deux premiers thyristors 208, 210. Lorsque le convertisseur 2000 réalise une conversion ou une adaptation d'une tension continue vers une tension alternative, les composants utilisés pour les commutations sont les transistors 204, 206 et les deux autres thyristors 212, 214. Ainsi, dans les deux cas, les deux thyristors non utilisés pour la commutation sont commandés par le circuit de commande 124 de manière analogue aux premier et deuxième thyristors 112, 114 comme précédemment décrit pour le système de contrôle de batterie de véhicule 1000, c'est-à-dire en utilisant le thyristor qui est polarisé en inverse pour réaliser une conduction en inverse chargeant la capacité de stockage 118, puis l'autre thyristor polarisé en direct pour réaliser ensuite la précharge de la capacité de stockage 118 si la tension aux bornes de la capacité de stockage 118 est supérieure au seuil de court-circuit.

Le dispositif 100 peut être utilisé pour d'autres types de convertisseur de puissance, comme par exemple des convertisseurs unidirectionnels tels qu'un convertisseur intégrant un pont mixte couplé à un circuit de type « Boost ».

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Dispositif (100) de détection de court-circuit dans un circuit de courant continu comprenant au moins une source de tension (102), un bus comportant au moins deux éléments conducteurs (104, 106) chacun couplé à l'une des bornes de la source de tension (102), des premier et deuxième thyristors (112, 114) couplés à la source de tension (102) et au bus, et au moins un élément capacitif formant une capacité de stockage (118) dont chacune des électrodes est couplée à l'un des deux éléments conducteurs (104, 106) du bus,

   **caractérisé en ce que** le dispositif (100) de détection de court-circuit comprenant au moins un circuit de commande (124) configuré pour commander les polarisations et les régimes de fonctionnement des premier et deuxième thyristors (112, 114) tel que :

   • lors d'une phase de détection de court-circuit, le premier thyristor (112) est mis à l'état bloqué et le deuxième thyristor (114) est polarisé en inverse et conduit un courant inverse non nul chargeant la capacité de stockage (118), puis une tension aux bornes de la capacité de stockage (118) est déterminée ; puis
   • si la tension déterminée aux bornes de la capacité de stockage (118) est inférieure ou égale à une valeur seuil de court-circuit, les premier et deuxième thyristors (112, 114) sont bloqués, ou si la tension déterminée aux bornes de la capacité de stockage (118) est supérieure à la valeur seuil de court-circuit, la capacité de stockage (118) est préchargée en bloquant le deuxième thyristor (114) et en rendant passant le premier thyristor (112).

2. Dispositif (100) de détection de court-circuit selon la revendication 1, dans lequel la valeur seuil de court-circuit est égale à 0.

3. Dispositif (100) de détection de court-circuit selon l'une des revendications précédentes, dans lequel :

   • la source de tension (102) est une source de tension continue comportant au moins une batterie ;
   • le circuit de courant continu comporte au moins un premier commutateur (108) couplant une borne positive de la batterie à un premier des deux éléments conducteurs (104) du bus, et au moins un deuxième commutateur (110) couplant une borne négative de la batterie à un deuxième des deux éléments conducteurs (106) du bus ;
   • au moins l'un des premier et deuxième commutateurs (108, 110) correspond à un relais ;
   • le circuit de courant continu comporte un circuit de décharge de la capacité de stockage (118) incluant au moins un troisième commutateur (120) couplé en série à au moins une résistance de décharge (122), le circuit de décharge étant couplé en parallèle de la capacité de stockage (118) ;
   • le premier thyristor (112) fait partie d'un circuit de précharge incluant en outre une résistance de précharge (116) couplée en série au premier thyristor (112), le circuit de précharge étant couplé en parallèle de l'un des premier et deuxième commutateurs (108, 110) et tel que la cathode du premier thyristor (112) soit couplée à la borne négative de la batterie ou que l'anode du premier thyristor (112) soit couplée à la borne positive de la batterie ;
   • le deuxième thyristor (114) est couplé en parallèle de l'un des premier et deuxième commutateurs (108, 110) et tel que l'anode du deuxième thyristor (114) est couplée à la borne négative de la batterie ou la cathode du deuxième thyristor (114) est couplée à la borne positive de la batterie.

4. Dispositif (100) de détection de court-circuit selon la revendication 3, dans lequel :

• le circuit de commande (124) est configuré pour appliquer des signaux de commande sur les gâchettes des premier et deuxième thyristors (112, 114), ou
• le dispositif (100) de détection de court-circuit comporte en outre une diode Zener (130) et un circuit RC (132, 134), l'anode de la diode Zener (130) étant couplée à la gâchette du premier thyristor (112), la cathode de la diode Zener (130) étant couplée à l'anode du deuxième thyristor (114) et à une première borne du circuit RC (132, 134), une deuxième borne du circuit RC (132, 134) étant couplée à la cathode du premier thyristor (112).

5. Dispositif (100) de détection de court-circuit selon l'une des revendications 3 ou 4, dans lequel le circuit de commande (124) est configuré pour :

• avant la phase de détection de court-circuit, fermer le premier commutateur (108), puis réaliser une mesure initiale de la tension aux bornes de la capacité de stockage (118) ; puis
• mettre en œuvre la phase de détection de court-circuit si la tension initialement mesurée aux bornes de la capacité de stockage (118) est inférieure ou égale à la valeur seuil de court-circuit, ou précharger directement la capacité de stockage (118) si la tension initialement mesurée aux bornes de la capacité de stockage (118) est supérieure à la valeur seuil de court-circuit.

6. Dispositif (100) de détection de court-circuit selon l'une des revendications 3 à 5, dans lequel, lorsque l'anode du deuxième thyristor (114) est couplée à la borne négative de la batterie, le circuit de commande (124) est configuré pour commander le premier commutateur (108) tel qu'il soit passant lors de la phase de détection de court-circuit et lors de la précharge de la capacité de stockage (118).

7. Dispositif (100) de détection de court-circuit selon l'une des revendications 3 à 6, dans lequel le circuit de commande (124) est configuré tel que, après la précharge de la capacité de stockage (118), les premier et deuxième commutateurs (108, 110) sont mis à l'état passant et les premier et deuxième thyristors (112, 114) sont bloqués.

8. Dispositif (100) de détection de court-circuit selon l'une des revendications 3 à 7, dans lequel le troisième commutateur (120) est un troisième thyristor, et dans lequel le circuit de commande (124) est configuré pour appliquer un signal de commande sur la gâchette du troisième thyristor.

9. Dispositif (100) de détection de court-circuit selon l'une des revendications 3 à 8, dans lequel, lors d'une phase de déconnexion de la batterie vis-à-vis du bus mise en œuvre après la précharge de la capacité de stockage (118), le circuit de commande (124) est configuré pour rendre passant le troisième commutateur (120) après avoir ouvert les premier et deuxième commutateurs (108, 110).

10. Dispositif (100) de détection de court-circuit selon l'une des revendications 3 à 9, dans lequel, lors de la détermination de la tension aux bornes de la capacité de stockage (118) mise en œuvre pendant la phase de détection de court-circuit, le circuit de commande (124) est configuré pour bloquer le deuxième thyristor (114).

11. Système (1000) de contrôle de batterie de véhicule, comprenant au moins un dispositif (100) de détection de court-circuit selon l'une des revendications 3 à 10.

12. Convertisseur (2000) de puissance électrique comprenant au moins un dispositif (100) de détection de court-circuit selon l'une des revendications 1 ou 2.

13. Convertisseur (2000) de puissance électrique selon la revendication 12, dans lequel les premier et deuxième thyristors (112, 114) font partie des cellules de commutation du convertisseur (2000) de puissance électrique.

**Patentansprüche**

1. Eine Kurzschlussdetektionssvorrichtung (100) zum Detektieren von Kurzschlüssen in einer Gleichstromschaltung, aufweisend wenigstens eine Spannungsquelle (102), einen Bus, der wenigstens zwei leitende Elemente (104, 106) aufweist, die jeweils mit einem der Anschlüsse der Spannungsquelle (102) gekoppelt sind, einen ersten und einen zweiten Thyristor (112, 114), die mit der Spannungsquelle (102) und dem Bus gekoppelt sind, und wenigstens ein kapazitives Element, das einen Speicherkondensator (118) bildet, dessen Elektroden jeweils mit einem der leitenden Elemente (104, 106) des Busses gekoppelt sind,
**dadurch gekennzeichnet, dass** die Kurzschlussdetektionsvorrichtung (100) wenigstens eine Steuerschaltung (124) aufweist, die konfiguriert ist zum Steuern der Vorspannung und der Betriebsmodi des ersten und des zweiten Thyristors (112, 114) derart, dass:

• während einer Detektionsphase eines Kurzschlusses der erste Thyristor (112) in einen Aus-Zustand versetzt wird und der zweite Thyristor (114) in Sperrrichtung vorgespannt wird und einen von Null verschiedenen Sperrstrom leitet, der den Speicherkondensator (118) auflädt, dann eine Spannung an den Anschlüssen des Speicherkondensators (118) bestimmt wird; dann

• wenn die ermittelte Spannung an den Anschlüssen des Speicherkondensators (118) kleiner oder gleich einem Kurzschluss-Schwellenwert ist, der erste und der zweite Thyristor (112, 114) ausgeschaltet werden, oder wenn die bestimmte Spannung an den Anschlüssen des Speicherkondensators (118) höher als der Kurzschluss-Schwellenwert ist, der Speicherkondensator (118) durch Ausschalten des zweiten Thyristors (114) und Einschalten des ersten Thyristors (112) vorgeladen wird.

2.    Die Kurzschlussdetektionssvorrichtung (100) nach Anspruch 1, wobei der Kurzschluss-Schwellenwert gleich 0 ist.

3.    Die Kurzschlussdetektionssvorrichtung (100) nach einem der vorhergehenden Ansprüche, wobei:

     • die Spannungsquelle (102) eine Gleichspannungsquelle ist, die wenigstens eine Batterie aufweist;
     • die Gleichstromschaltung wenigstens einen ersten Schalter (108) aufweist, der einen positiven Anschluss der Batterie mit einem ersten der beiden leitenden Elemente (104) des Busses koppelt, und wenigstens einen zweiten Schalter (110) aufweist, der einen negativen Anschluss der Batterie mit einem zweiten der beiden leitenden Elemente (106) des Busses koppelt;
     • wenigstens einer der ersten und zweiten Schalter (108, 110) ein Relais ist;
     • die Gleichstromschaltung eine Entladungsschaltung des Speicherkondensators (118) aufweist, die wenigstens einen dritten Schalter (120) aufweist, der in Reihe mit wenigstens einem Entladungswiderstand (122) gekoppelt ist, wobei die Entladungsschaltung parallel zum Speicherkondensator (118) gekoppelt ist;
     • der erste Thyristor (112) Teil einer Vorladeschaltung ist, die auch einen Vorladewiderstand (116) enthält, der in Reihe mit dem ersten Thyristor (112) gekoppelt ist, wobei die Vorladeschaltung parallel zu einem der ersten und zweiten Schalter (108, 110) gekoppelt ist, und so, dass die Kathode des ersten Thyristors (112) mit dem negativen Anschluss der Batterie gekoppelt ist oder die Anode des ersten Thyristors (112) mit dem positiven Anschluss der Batterie gekoppelt ist;
     • der zweite Thyristor (114) parallel zu einem der ersten und zweiten Schalter (108, 110) gekoppelt ist, und zwar so, dass die Anode des zweiten Thyristors (114) mit dem negativen Anschluss der Batterie gekoppelt ist oder die Kathode des zweiten Thyristors (114) mit dem positiven Anschluss der Batterie gekoppelt ist.

4.    Die Kurzschlussdetektionssvorrichtung (100) nach Anspruch 3, wobei:

     • die Steuerschaltung (124) konfiguriert ist zum Anlegen von Steuersignalen an die Gates des ersten und zweiten Thyristors (112, 114), oder
     • die Kurzschlussdetektionssvorrichtung (100) ferner eine Zenerdiode (130) und einen RC-Kreis (132, 134) aufweist, wobei die Anode der Zenerdiode (130) mit dem Gate des ersten Thyristors (112) gekoppelt ist, wobei die Kathode der Zenerdiode (130) mit der Anode des zweiten Thyristors (114) und mit einem ersten Anschluss des RC-Kreises (132, 134) gekoppelt ist, wobei ein zweiter Anschluss des RC-Kreises (132, 134) mit der Kathode des ersten Thyristors (112) gekoppelt ist.

5.    Die Kurzschlussdetektionssvorrichtung (100) nach Anspruch 3 oder 4, wobei die Steuerschaltung (124) konfiguriert ist zum:

     • vor der Kurzschlussdetektionsphase, Schließen des ersten Schalters (108), dann Durchführen einer Anfangsmessung der Spannung an den Anschlüssen des Speicherkondensators (118); dann
     • Einleiten der Kurzschlussdetektionsphase, wenn die Anfangsspannungsmessung an den Anschlüssen des Speicherkondensators (118) kleiner oder gleich dem Kurzschluss-Schwellenwert ist, oder direktes Vorladen des Speicherkondensators (118), wenn die Spannung, die anfänglich an den Anschlüssen des Speicherkondensators (118) gemessen wurde, höher als der Schwellenwert für Kurzschluss ist.

6.    Die Kurzschlussdetektionssvorrichtung (100) nach einem der Ansprüche 3 bis 5, wobei, wenn die Anode des zweiten Thyristors (114) mit dem negativen Anschluss der Batterie gekoppelt ist, die Steuerschaltung (124) konfiguriert ist zum Steuern des ersten Schalters (108), so dass er während der Kurzschlussdetektionsphase und während des Vorladens des Speicherkondensators (118) eingeschaltet ist.

7.    Die Kurzschlussdetektionssvorrichtung (100) nach einem der Ansprüche 3 bis 6, wobei die Steuerschaltung (124) konfiguriert ist, so dass nach dem Vorladen des Speicherkondensators (118) der erste und der zweite Schalter (108, 110) eingeschaltet und der erste und der zweite Thyristor (112, 114) ausge-

schaltet werden.

**8.** Die Kurzschlussdetektionssvorrichtung (100) nach einem der Ansprüche 3 bis 7, wobei der dritte Schalter (120) ein dritter Thyristor ist und die Steuerschaltung (124) konfiguriert ist zum Anlegen eines Steuersignals an das Gate des dritten Thyristors.

**9.** Die Kurzschlussdetektionssvorrichtung (100) nach einem der Ansprüche 3 bis 8, wobei während einer Trennungsphase der Batterie vom Bus, die nach dem Vorladen des Speicherkondensators (118) durchgeführt wird, die Steuerschaltung (124) konfiguriert ist, zum Einschalten des dritten Schalters (120) nach dem Öffnen des ersten und zweiten Schalters (108, 110).

**10.** Die Kurzschlussdetektionssvorrichtung (100) nach einem der Ansprüche 3 bis 9, wobei während der Messung der Spannung an den Anschlüssen des Speicherkondensators (118), die während der Kurzschlussdetektionsphase durchgeführt wird, die Steuerschaltung (124) konfiguriert ist, zum Ausschalten des zweiten Thyristors (114).

**11.** Ein Fahrzeugbatteriesteuersystem (1000), das wenigstens eine Kurzschlussdetektionssvorrichtung (100) nach einem der Ansprüche 3 bis 10 aufweist.

**12.** Ein elektrischer Leistungswandler (2000), der wenigstens eine Kurzschlussdetektionsvorrichtung (100) nach Anspruch 1 oder 2 aufweist.

**13.** Der elektrische Leistungswandler (2000) nach Anspruch 12, wobei der erste und der zweite Thyristor (112, 114) Teil von Kommutierungszellen des elektrischen Leistungswandlers (2000) sind.

**Claims**

**1.** A short-circuit detection device (100) for detecting short-circuits in a direct current circuit, comprising at least one voltage source (102), a bus comprising at least two conducting elements (104, 106) each coupled to either one of the terminals of the voltage source (102), first and second thyristors (112, 114) coupled to the voltage source (102) and to the bus, and at least one capacitive element forming a storage capacitor (118), electrodes of which are each coupled to either one of the conducting elements (104, 106) of the bus,
**characterized in that** the short-circuit detection device (100) comprises at least one control circuit (124) configured to control the biasing and the modes of operation of the first and second thyristors (112, 114) such that:

• during a detection phase of a short-circuit, the first thyristor (112) is set to an off state and the second thyristor (114) is reverse-biased and conducts a non-zero reverse current that charges the storage capacitor (118), then a voltage at the terminals of the storage capacitor (118) is determined; then
• if the determined voltage at the terminals of the storage capacitor (118) is lower than or equal to a short-circuit threshold value, the first and second thyristors (112, 114) are turned off, or if the determined voltage at the terminals of the storage capacitor (118) is higher than the short-circuit threshold value, the storage capacitor (118) is pre-charged by turning off the second thyristor (114) and by turning on the first thyristor (112).

**2.** The short-circuit detection device (100) according to claim 1, where the short-circuit threshold value is equal to 0.

**3.** The short-circuit detection device (100) according to any one of the previous claims, wherein:

• the voltage source (102) is a direct voltage source comprising at least one battery;
• the direct current circuit comprises at least a first switch (108) coupling a positive terminal of the battery to a first one of the two conducting elements (104) of the bus, and at least a second switch (110) coupling a negative terminal of the battery to a second one of the two conducting elements (106) of the bus;
• at least one of the first and second switches (108, 110) is a relay;
• the direct current circuit comprises a discharge circuit of the storage capacitor (118) comprising at least a third switch (120) coupled in series with at least one discharge resistor (122), the discharge circuit being coupled in parallel with the storage capacitor (118);
• the first thyristor (112) is part of a pre-charging circuit that also includes a pre-charging resistor (116) coupled in series with the first thyristor (112), wherein the pre-charging circuit is coupled in parallel with one of the first and second switches (108, 110), and such that the cathode of the first thyristor (112) is coupled to the negative terminal of the battery or the anode of the first thyristor (112) is coupled to the positive terminal of the battery;
• the second thyristor (114) is coupled in parallel with one of the first and second switches (108, 110) and such that the anode of the second thyristor (114) is coupled to the negative terminal of the battery or the cathode of the second thyristor (114) is coupled to the positive terminal

4. A short-circuit detection device (100) according to claim 3, in which:

    • the control circuit (124) is configured to apply control signals to gates of the first and second thyristors (112, 114), or
    • the short-circuit detection device (100) further comprises a Zener diode (130) and an RC circuit (132, 134), the anode of the Zener diode (130) being coupled to the gate of the first thyristor (112), the cathode of the Zener diode (130) being coupled to the anode of the second thyristor (114) and to a first terminal of the RC circuit (132, 134), a second terminal of the RC circuit (132, 134) being coupled to the cathode of the first thyristor (112).

5. The short-circuit detection device (100) according to claim 3 or 4, wherein the control circuit (124) is configured to:

    • before the short-circuit detection phase, close the first switch (108), then perform an initial measurement of the voltage at the terminals of the storage capacitor (118); then
    • initiate the short-circuit detection phase if the initial voltage measurement at the terminals of the storage capacitor (118) is lower than or equal to the short-circuit threshold value, or directly pre-charge the storage capacitor (118) if the voltage initially measured at terminals of the storage capacitor (118) is higher than the threshold value of short-circuit.

6. The short-circuit detection device (100) according to any one of claims 3 to 5, wherein, if the anode of the second thyristor (114) is coupled to the negative terminal of the battery, the control circuit (124) is configured to control the first switch (108) so that it is on during the short-circuit detection phase and during the pre-charging of the storage capacitor (118).

7. The short-circuit detection device (100) according to any one of claims 3 to 6, wherein the control circuit (124) is configured such that, after the pre-charging of the storage capacitor (118), the first and second switches (108, 110) are turned on and the first and second thyristors (112, 114) are turned off.

8. The short-circuit detection device (100) according to any one of claims 3 to 7, wherein the third switch (120) is a third thyristor, and the control circuit (124) is configured to apply a control signal to the gate of the third thyristor.

9. The short-circuit detection device (100) according to any one of claims 3 to 8, wherein, during a disconnection phase of the battery from the bus performed after the pre-charging of the storage capacitor (118), the control circuit (124) is configured to turn on the third switch (120) after the opening of the first and second switches (108, 110).

10. The short-circuit detection device (100) according to any one of claims 3 to 9, wherein, during the measurement of the voltage at the terminals of the storage capacitor (118) implemented during the short-circuit detection phase, the control circuit (124) is configured to turn off the second thyristor (114).

11. A vehicle battery control system (1000) comprising at least one short-circuit detection device (100) according to any one of claims 3 to 10.

12. An electrical power converter (2000) comprising at least one short-circuit detection device (100) according to claim 1 or 2.

13. The electrical power converter (2000) according to claim 12, wherein the first and second thyristors (112, 114) are part of commutation cells of the electrical power converter (2000).

**Fig. 1**

**Fig. 2**

Fig. 3

Fig. 4

**Fig. 5**

**Fig. 6**

## RÉFÉRENCES CITÉES DANS LA DESCRIPTION

**Documents brevets cités dans la description**

- CN 101515710